# EUROPEAN PATENT APPLICATION

(11) **EP 4 564 034 A1**
(43) Date of publication of application: **04.06.2025**
(21) Application number: 23863421.6
(22) Date of filing: 01.09.2023
(51) Int. Cl.: G01R 31/389, G01R 31/3835, G01R 19/00

(54) **BATTERY MANAGEMENT DEVICE, AND METHOD FOR OPERATING SAME**

(30) Priority: 06.09.2022 KR 20220113105
(71) Applicant: LG Energy Solution, Ltd., Seoul 07335 (KR)
(72) Inventor: KIM, Sang Yeon, Daejeon 34122 (KR); SONG, Hyeon Jin, Daejeon 34122 (KR); KIM, Ki Hyun, Daejeon 34122 (KR)
(74) Representative: Plasseraud IP
(86) International application number: PCT/KR2023/013105
(87) International publication number: WO 2024/053946

(57) **Abstract**

A battery management apparatus according to an embodiment includes a first comparator configured to compare a voltage of a battery cell with a first reference voltage, a switching circuit configured to set a path in which the battery cell is electrically connected to an impedance calculation unit to a first path or a second path, based on a comparison result of the first comparator, and the impedance calculation unit configured to calculate an impedance of the battery cell based on a first voltage applied through the first path or a second voltage applied through the second path.

## Description

### [TECHNICAL FIELD]

### CROSS-REFERENCE TO RELATED APPLICATION

This application claims priority to and the benefit of Korean Patent Application No. 10-2022-0113105 filed in the Korean Intellectual Property Office on September 6, 2022, the entire contents of which are incorporated herein by reference.

### TECHNICAL FIELD

Embodiments disclosed herein relate to a battery management apparatus and an operating method thereof.

### [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. Among them, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Electrochemical impedance spectroscopy (EIS) is a technique for extracting an equivalent circuit parameter of a battery based on an impedance value measured after applying alternating current power per frequency to a battery, and is used for estimating a lifetime or state of the battery. However, unlike for a general battery cell having an operating voltage of about 3 to 4.2 V, for a battery cell having an operating voltage of 2.5 V or less, voltage measurement may be difficult to perform in an impedance measurement unit, requiring a separate voltage amplifier for amplifying a measurement voltage. Moreover, for a battery cell having an operating voltage of 1 V or less, current flowing through a resistor unit for impedance measurement is reduced to 1/3 or less, requiring a separate amplifier including parallel resistors to amplify current. As a result, an existing EIS measurement device has to separately use a circuit for measuring a general battery cell and a circuit for measuring a low-voltage battery cell according to an operating voltage of a battery cell.

### [DISCLOSURE]

### [TECHNICAL PROBLEM]

Embodiments disclosed herein aim to provide a battery management apparatus capable of impedance measurement for both a general battery cell and a low-voltage battery cell.

Embodiments disclosed herein aim to provide a battery management apparatus capable of reducing a measurement error caused by noise.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to an embodiment includes a first comparator configured to compare a voltage of a battery cell with a first reference voltage, a switching circuit configured to set a path in which the battery cell is electrically connected to an impedance calculation unit to a first path or a second path, based on a comparison result of the first comparator, and the impedance calculation unit configured to calculate an impedance of the battery cell based on a first voltage applied through the first path or a second voltage applied through the second path.

The battery management apparatus according to an embodiment may further include a voltage amplifier arranged on the second path, in which the voltage amplifier is further configured to amplify the voltage of the battery cell to the second voltage, when the path is set to the second path.

In the battery management apparatus according to an embodiment, the switching circuit may include a first switch arranged on the first path and a second switch arranged on the second path, and when the voltage of the battery cell is greater than or equal to the first reference voltage, the path may be set to the first path by short-circuiting the first switch and opening the second switch, and when the voltage of the battery cell is less than the first reference voltage, the path may be set to the second path by opening the second switch and short-circuiting the second switch.

The battery management apparatus according to an embodiment may further include a third switch electrically connected to the battery cell, in which the third switch alternates between on and off according to a designated period to generate alternating current (AC) input to the battery cell.

The battery management apparatus according to an embodiment may include a current controller configured to adjust a magnitude of the alternating current based on a result of comparing the voltage of the battery cell with a second reference voltage.

In the battery management apparatus according to an embodiment, the current controller may further include a variable resistor, and when the voltage of the battery cell is greater than or equal to the second reference voltage, the variable resistor may be set to have a first resistance value, and when the voltage of the battery cell is less than the second reference voltage, the variable resistor may be set to have a second resistance value less than the first resistance value.

In the battery management apparatus according to an embodiment, the first comparator may be further configured to adjust the first reference voltage based on a change of the voltage of the battery cell in a predetermined time window.

In the battery management apparatus according to an embodiment, the first comparator may be further configured to increase the first reference voltage when the voltage of the battery cell increases by a first designated level or more in a predetermined time window and to reduce the first reference voltage when the voltage of the battery cell decreases by a second designated level or more in a predetermined time window.

An operating method of a battery management apparatus according to an embodiment includes comparing a voltage of a battery cell with a first reference voltage, setting a path in which the battery cell is electrically connected to an impedance calculation unit to a first path or a second path, based on a result of comparing the voltage of the battery cell with the first reference voltage, and calculating an impedance of the battery cell based on a first voltage applied to the impedance calculation unit through the first path or a second voltage applied to the impedance calculation unit through the second path.

The operating method of the battery management apparatus according to an embodiment may further include amplifying the voltage of the battery cell to the second voltage through a voltage amplifier arranged on the second path, when the path is set to the second path.

The operating method of the battery management apparatus according to an embodiment may further include a third switch, electrically connected to the battery cell, alternating between on and off according to a designated period to generate alternating current (AC) input to the battery cell.

The operating method of the battery management apparatus according to an embodiment may further include adjusting a magnitude of the alternating current based on a result of comparing the voltage of the battery cell with a second reference voltage.

In the operating method of the battery management apparatus according to an embodiment, the adjusting of the magnitude of the alternating current may include, when the voltage of the battery cell is greater than or equal to the second reference voltage, setting a variable resistor arranged on a path through which the alternating current flows to have a first resistance value, and when the voltage of the battery cell is less than the second reference voltage, setting the variable resistor to have a second resistance value less than the first resistance value.

The operating method of the battery management apparatus according to an embodiment may further include adjusting the first reference voltage based on a change of the voltage of the battery cell in a predetermined time window.

In the operating method of the battery management apparatus according to an embodiment, the adjusting of the first reference voltage may include increasing the first reference voltage when the voltage of the battery cell increases by a first designated level or more in a predetermined time window and reducing the first reference voltage when the voltage of the battery cell decreases by a second designated level or more in a predetermined time window.

### [ADVANTAGEOUS EFFECTS]

With a battery management apparatus according to an embodiment, when a voltage of a battery cell is less than a first reference voltage (e.g., 2.5 V), an impedance may be calculated using a voltage applied through a path including a voltage amplifier through switching. With the battery management apparatus according to an embodiment, when the voltage of the battery cell is less than a second reference voltage (e.g., 1V), a magnitude of an alternating current flowing in a battery cell may be increased. Thus, the impedance may be easily measured for both a general battery cell and a low-voltage battery cell without separately using a measurement device according to an operating voltage of the battery cell.

Moreover, when an operating voltage of the battery cell is close to a reference voltage during impedance measurement, an operation for the general battery cell and an operation for the low-voltage battery cell may be repeated due to noise, causing a measurement error, but according to an embodiment, by adjusting a comparison reference voltage according to whether the voltage of the battery cell instantly increases or decreases,, the measurement error caused by noise may be reduced.

Moreover, various effects recognized directly or indirectly from the disclosure may be provided.

### [DESCRIPTION OF DRAWINGS]

In order to more clearly describe technical solutions of embodiments disclosed herein or the prior art, the drawings required in the description of the embodiments are briefly introduced below. It should be understood that the following drawings are for the purpose of explaining the embodiments of the present specification and not for limiting purposes. In addition, representations of some components in the drawings may be exaggerated or omitted for clarity of explanation.
FIG. 1A is a view showing a structure for measuring an EIS for a battery cell, according to an embodiment.
FIG. 1B is a view showing a structure for measuring an EIS for a battery cell, according to an embodiment.
FIG. 2 is a view showing a structure of a battery management apparatus according to an embodiment.
FIG. 3A is a view showing a connection relationship between components when a voltage of a battery cell is within a first voltage range, according to an embodiment.
FIG. 3B is a view showing a connection relationship between components when a voltage of a battery cell is within a second voltage range, according to an embodiment.
FIG. 3C is a view showing a connection relationship between components when a voltage of a battery cell is within a third voltage range, according to an embodiment.
FIG. 4 is a flowchart showing an operating method of a battery management apparatus according to an embodiment.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

Although terms used herein are selected with general terms popularly used at present under the consideration of functions in the disclosure, the terms may vary according to the intention of those of ordinary skill in the art, custom, or introduction of new technology. In addition, in a specific case, the applicant voluntarily may select terms, and in this case, the meaning of the terms may be disclosed in a corresponding description part of the present specification. Therefore, the terms used herein should be defined not by the simple names of the terms but by the substantial meaning of the terms and the contents throughout the disclosure.

Moreover, terms defined in the present disclosure are used for only describing a specific exemplary embodiment and may not have an intention to limit the scope of other exemplary embodiments. It is to be understood that the singular forms include plural references unless the context clearly dictates otherwise. Herein, expressions such as "first" and "second" are used to distinguish components from each other, and do not mean a rank or order among components.

Hereinbelow, preferred embodiments of a battery management apparatus and an operating method thereof will be described with reference to the drawings.

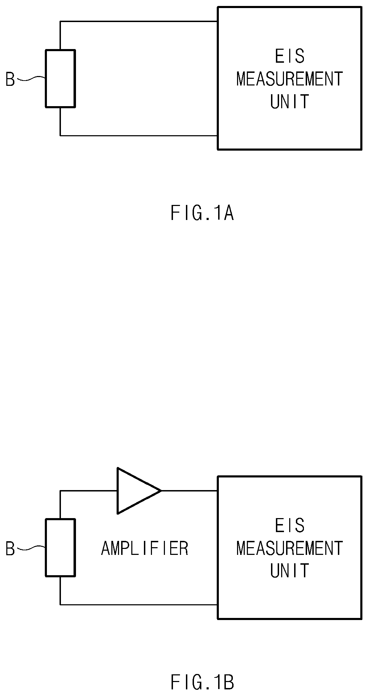

FIG. 1A is a view showing a structure for measuring an EIS for a battery cell, according to an embodiment.

For a general battery cell B operating in a general voltage range (e.g., about 3 to 4.2 V), an alternating current impedance may be measured through an EIS measurement unit without a particular additional circuit. The EIS measurement unit may measure and indicate, for each frequency, an impedance response output after application of an alternating current signal to the battery cell B.

For example, the EIS measurement unit may include an alternating current signal generation unit for generating an alternating current signal for each frequency and inputting the alternating current signal to a battery cell and an impedance calculation unit for receiving an output signal (e.g., a voltage value) of a battery for the input alternating current signal and calculating an impedance for each frequency. Parameters (e.g., internal resistance, etc.) of the battery cell B may be obtained from an impedance response according to frequency sweep, thus obtaining state information of a battery cell, such as deterioration, remaining lifetime, abnormality, etc.

FIG. 1B is a schematic diagram showing a structure for measuring an EIS for a battery cell, according to an embodiment.

Unlike for a general battery cell, for a low-voltage battery cell operating in a voltage range less than a first reference voltage (e.g., 2.5 V), a magnitude of a voltage applied to the EIS measurement unit may be reduced.

Moreover, for a low-voltage battery cell operating in a voltage range less than a second reference voltage (e.g., 1 V), the magnitude of the voltage applied to the EIS measurement unit may be reduced and a magnitude of current flowing through a resistor of the EIS measurement unit may be reduced in proportional to the magnitude of the voltage. For example, in the same circuit, when compared to a battery cell having an operating voltage of 3 V, current flowing through a low-voltage battery cell having an operating voltage of 1 V is reduced to 1/3 (Ohm's law, V = I * R).

Thus, generally, the EIS measurement circuit for the low-voltage battery cell may separately include a voltage amplifier for amplifying low voltage or a current amplifier for amplifying alternating current flowing through the battery cell, like the circuit structure of FIG. 1B. For example, the voltage amplifier may include an inverting amplifier. The current amplifier may include one or more parallel resistors for increasing current by a rate of decreasing voltage.

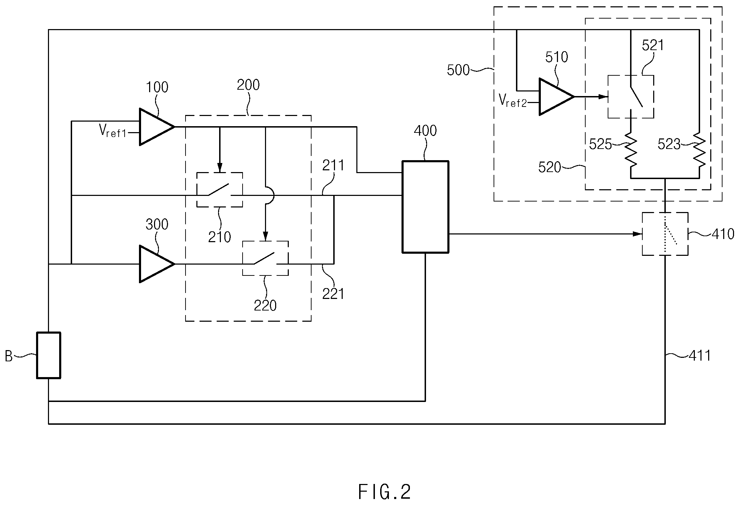

FIG. 2 is a schematic diagram showing a structure of a battery management apparatus according to an embodiment.

Referring to FIG. 2, a battery management apparatus according to an embodiment may include a first comparator 100, a switching circuit 200, a voltage amplifier 300, an impedance calculation unit 400, a third switch 410, and/or a current controller 500. According to some embodiments, in the battery management apparatus, at least one of components of FIG. 2 may be omitted or one or more other components may be added.

The first comparator 100 may be configured to compare a voltage of the battery cell B with a first reference voltage and transmit a result thereof to the switching circuit 200. According to an embodiment, the first reference voltage may be set in a range of 1 to 3 V. For example, the first reference voltage may be set to 2.5 V.

The switching circuit 200 may set a path in which the battery cell B and the impedance calculation unit 400 are electrically connected to each other as a first path 211 or a second path 221 based on a comparison result of the first comparator 100.

According to an embodiment, the switching circuit 200 may be configured to electrically connect the battery cell B to the impedance calculation unit 400 through the first path 211 not including the voltage amplifier 300, when the voltage of the battery cell B is greater than or equal to the first reference voltage. According to an embodiment, the switching circuit 200 may be configured to electrically connect the battery cell B to the impedance calculation unit 400 through the second path 221 including the voltage amplifier 300, when the voltage of the battery cell B is less than the first reference voltage.

According to an embodiment, the switching circuit 200 may include a first switch 210 and/or a second switch 220. According to an embodiment, the switching circuit 200 may be configured to electrically connect the battery cell B to the impedance calculation unit 400 through the first path 211 by short-circuiting the first switch 210 arranged on the first path 211 and opening the second switch 220 arranged on the second path 221 including the voltage amplifier 300, when the voltage of the battery cell B is greater than or equal to the first reference voltage. According to an embodiment, the switching circuit 200 may be configured to electrically connect the battery cell B to the impedance calculation unit 400 through the second path 221 by opening the first switch 210 arranged on the first path 211 and short-circuiting the second switch 220 arranged on the second path 221 including the voltage amplifier 300, when the voltage of the battery cell B is less than the first reference voltage. second path 221
first path 211 second path 221

The voltage amplifier 300 may amplify the voltage of the battery cell B, applied to the impedance calculation unit 400 through the second path 221. For example, the voltage amplifier 300 may be implemented with an inverting amplifier.

The impedance calculation unit 400 may calculate an impedance of the battery cell B based on a voltage applied through a designated path (e.g., the first path 211 or the second path 221). According to an embodiment, the impedance calculation unit 400 may calculate the impedance of the battery cell B based on a first voltage applied through the first path 211 or a second voltage applied through the second path 221. According to an embodiment, the impedance calculation unit 400 may calculate the impedance of the battery cell B based on the amount of change of the first voltage or the amount of change of the second voltage. According to another embodiment, the impedance calculation unit 400 may calculate the impedance of the battery cell B based on a differential value of the first voltage or a differential value of the second voltage.

As such, for the battery management apparatus according to an embodiment, the voltage of the battery cell may be compared with the first reference voltage, such that for the battery cell having the operating voltage greater than or equal to the first reference voltage, an impedance may be measured without voltage amplification, and for a battery cell of the first reference voltage or less, a voltage may be amplified through circuit switching and then an impedance may be measured.

The first path 211 the second path 221 According to an embodiment, the impedance calculation unit 400 may be an electrochemical impedance spectroscopy (EIS) measurement circuit for calculating an alternating current impedance for an alternating current voltage signal applied to a battery cell or a device including the same. According to an embodiment, the battery management apparatus may further include an alternating current signal generation unit for generating an alternating current signal for each frequency and inputting the same to the battery cell. According to an embodiment, the battery management apparatus may cause the third switch 410 electrically connected to the battery cell B to alternate between on and off according to a designated period to generate alternating current (AC) flowing to the battery cell B through the third path 411 including the battery cell B and the third switch 410. For example, the impedance calculation unit 400 may control the third switch 410 to alternate between on and off according to a designated period.

The current controller 500 may adjust a magnitude of the alternating current flowing to the battery cell B through the third path 411 based on a result of comparing the voltage of the battery cell B with the second reference voltage. Herein, the second reference voltage may be set less than the first reference voltage. For example, the second reference voltage may be set to 1 V.

According to an embodiment, the current controller 500 may include a second comparator 510 and/or a variable resistor 520.

According to an embodiment, the current controller 500 may compare the voltage of the battery cell B with the second reference voltage through the second comparator 510 and set a resistance value of the variable resistor 520 based on a result of the comparison.

The current controller 500 may adjust a magnitude of the alternating current flowing through the third path 411 by adjusting the resistance value of the variable resistor 520 based on the result of comparison of the second comparator 510. According to an embodiment, the current controller 500 may set a resistance value of the variable resistor 520 to a first resistance value, when the voltage of the battery cell B is greater than or equal to the second reference voltage. The current controller 500 may set a resistance value of the variable resistor 520 to a second resistance value, when the voltage of the battery cell B is less than the second reference voltage. Herein, the second resistance value may be less than the first resistance value.

According to an embodiment, the variable resistor 520 may include a fourth switch 521, a first resistor 523, and a second resistor 525. According to an embodiment, the first resistor 523 and the second resistor 525 may be connected to each other in parallel between the battery cell B and the third switch 410 on the third path 411. The fourth switch 521 may be connected serially to the second resistor 525.

According to an embodiment, the current controller 500 may open the fourth switch 521, when the voltage of the battery cell B is greater than or equal to the second reference voltage. In this case, the alternating current may flow through only the first resistor 523.

According to an embodiment, the current controller 500 may short-circuit the fourth switch 521, when the voltage of the battery cell B is less than the second reference voltage. In this case, the alternating current may flow through the first resistor 523 and the second resistor 525 connected in parallel. As such, the current controller 500 may increase the magnitude of the alternating current flowing in the battery cell B through additional parallel resistor connection, when the voltage of the battery cell B is less than the second reference voltage.

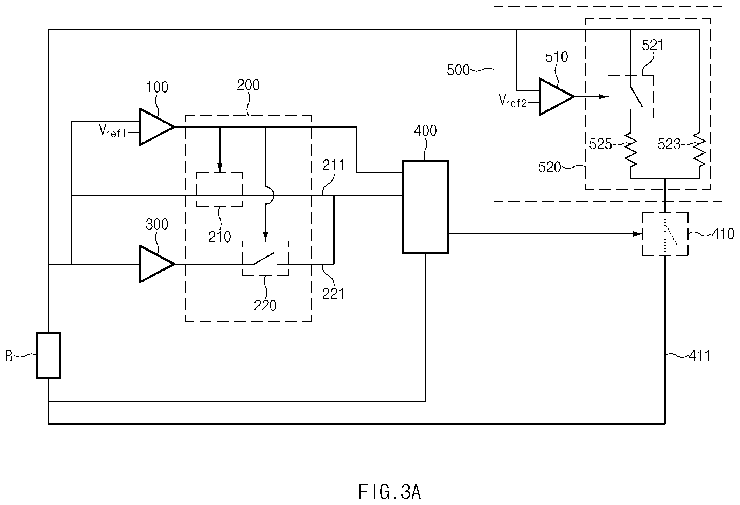

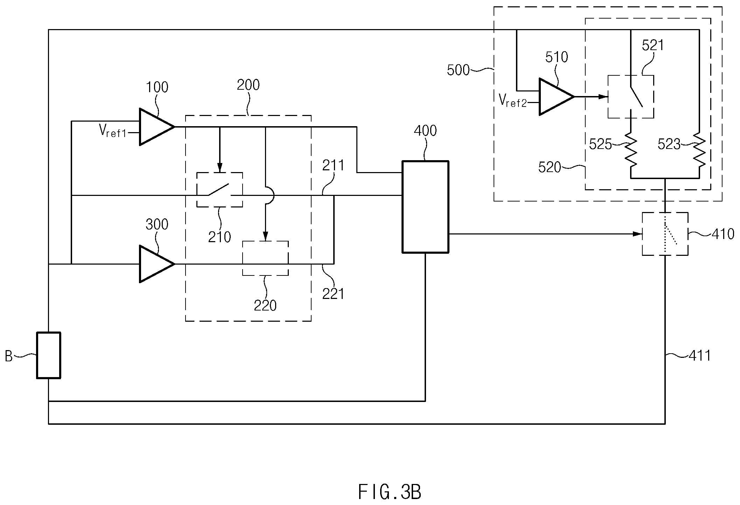

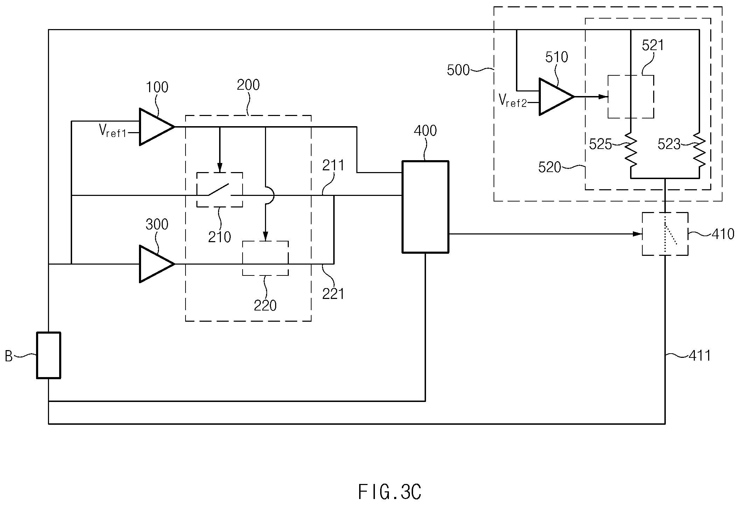

Hereinbelow, with reference to FIGS. 3A, 3B, and 3C, a description will be made of a connection relationship among components of the battery management apparatus when the voltage of the battery cell B is in a first voltage range, a second voltage range, or a third voltage range. Herein, the first voltage range may mean a range of at least the first reference voltage. The second voltage range may mean a range of at least a second reference voltage being less than the first reference voltage but not more than the first reference voltage. Herein, a third voltage range may mean a range less than the second reference voltage.

FIG. 3A is a view showing a connection relationship between components when a voltage of a battery cell is within a first voltage range, according to an embodiment.

Referring to FIG. 3A, the battery management apparatus may electrically connect the battery cell B to the impedance calculation unit 400 through the first path 211 not including the voltage amplifier 300, by short-circuiting the first switch 210 and opening the second switch 220, when the voltage of the battery cell B is within the first voltage range. The battery management apparatus may open the fourth switch 521 to allow the alternating current to flow through the first resistor 523 because the voltage of the battery cell B is greater than or equal to the second reference voltage. In this case, the impedance calculation unit 400 may calculate the impedance of the battery cell B based on the first voltage applied through the first path 211.

FIG. 3B is a view showing a connection relationship between components when a voltage of a battery cell is within a second voltage range, according to an embodiment.

Referring to FIG. 3B, the battery management apparatus may electrically connect the battery cell B to the impedance calculation unit 400 through the second path 221 including the voltage amplifier 300, by opening the first switch 210 and short-circuiting the second switch 220, when the voltage of the battery cell B is within the second voltage range. The battery management apparatus may open the fourth switch 521 to allow the alternating current to flow through the first resistor 523 because the voltage of the battery cell B is greater than or equal to the second reference voltage. In this case, the impedance calculation unit 400 may calculate the impedance of the battery cell B based on the second voltage applied through the second path 221. The second voltage may be a voltage amplified by the voltage amplifier 300.

FIG. 3C is a view showing a connection relationship between components when a voltage of a battery cell is within a third voltage range, according to an embodiment.

Referring to FIG. 3C, the battery management apparatus may electrically connect the battery cell B to the impedance calculation unit 400 through the second path 221 including the voltage amplifier 300, by opening the first switch 210 and short-circuiting the second switch 220, when the voltage of the battery cell B is within the third voltage range. The battery management apparatus may short-circuit the fourth switch 521 to allow the alternating current to flow through the first resistor 523 and the second resistor 525 connected in parallel because the voltage of the battery cell B is less than the second reference voltage. In this case, the impedance calculation unit 400 may calculate the impedance of the battery cell B based on the second voltage applied through the second path 221. The second voltage may be a voltage amplified by the voltage amplifier 300.

Meanwhile, in impedance measurement using a general comparator, when the voltage of the battery cell is not quite different from the reference voltage, some problem may occur. For example, when the impedance of the battery cell B is measured using the battery management apparatus of FIG. 2, assuming that a reference voltage of the first comparator 100 is 2.5 V and a voltage of the battery cell B is 2.5 V, an impedance may be calculated through the first path 211 not including the voltage amplifier 300 when a cell voltage instantly increases to 2.51 V due to noise, and the impedance may be calculated through the second path 221 including the voltage amplifier 300 when the cell voltage instantly decreases to 2.49 V. As such, when the battery cell voltage is not quite different from the reference voltage, circuit switching may repetitively occur due to noise, increasing a measurement error.

The battery management apparatus according to an embodiment for solving the problem may adjust the reference voltage of the first comparator 100 according to whether the voltage of the battery cell B is increasing or decreasing, thereby enabling the impedance calculation unit 400 to operate further stably and thus reducing an error.

According to an embodiment, the first comparator 100 may adjust the first reference voltage based on the voltage change of the battery cell B in a predetermined time window. For example, the first comparator 100 may increase the first reference voltage (e.g., 2.5 V) when the voltage of the battery cell B increases over a first designated level in a predetermined time window, and reduce the first reference voltage (e.g., 2.5 V) when the voltage of the battery cell B decreases by a second designated level in a predetermined time window.

In this case, the impedance may be calculated based on a voltage applied through the first path 211 not including the voltage amplifier 300 even when the voltage of the battery cell instantly increases to 2.51 V or instantly decreases to 2.49 V. second path 221

According to an embodiment, the impedance calculation unit 400 may be configured to have hysteresis characteristics.

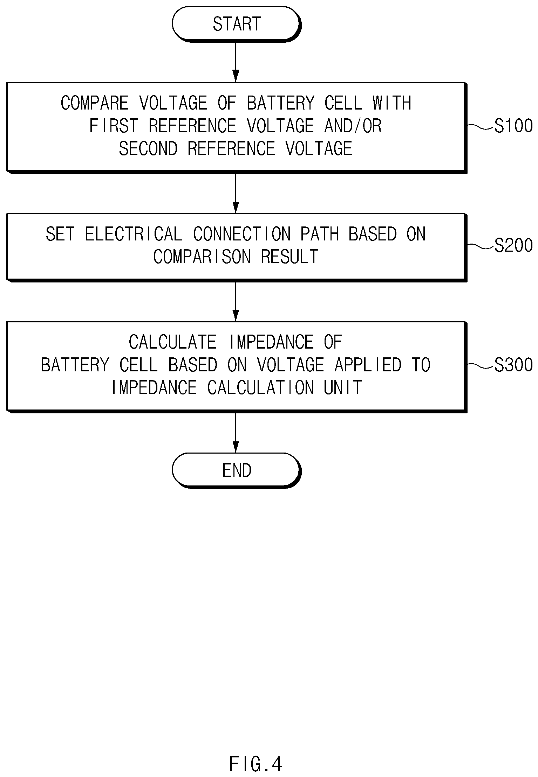

FIG. 4 is a flowchart showing an operating method of a battery management apparatus according to an embodiment. The operating method according to an embodiment may be executed by the battery management apparatus according to the foregoing embodiment, without being limited thereto, and may be executed by a battery management apparatus having other forms or structures.

Referring to FIG. 4, a voltage of a battery cell may be compared with a reference voltage in operation S100. According to an embodiment, the reference voltage may be set in a range of 1 to 3 V. For example, assuming that the reference voltage is 2.5 V, then it may be determined whether the battery cell is a general battery cell having an operating voltage of 3 V or greater or a low-voltage battery cell operating at a voltage less than the same.

In operation S100, the battery management apparatus may compare the voltage of the battery cell B with the first reference voltage and/or the second reference voltage. According to an embodiment, the first reference voltage may be set in a range of 1 to 3 V. For example, the first reference voltage may be set to 2.5 V. The second reference voltage may be set less than the first reference voltage. For example, the second reference voltage may be set to 1 V.

According to an embodiment, the battery management apparatus may adjust the first reference voltage based on the voltage change of the battery cell B in a predetermined time window. For example, the battery management apparatus may increase the first reference voltage when the voltage of the battery cell B increases by the first designated level or more in the predetermined time window. The battery management apparatus may reduce the first reference voltage when the voltage of the battery cell B decreases by the second designated level or more in the time window.

In operation S200, the battery management apparatus may set an electrical connection path therein based on a result of the comparison of operation S100.

According to an embodiment, the battery management apparatus may set a path in which the battery cell B and the impedance calculation unit 400 are electrically connected to each other as a first path 211 or a second path 221 based on a comparison result of operation S100. According to an embodiment, the battery management apparatus may electrically connect the battery cell B to the impedance calculation unit 400 through the first path 211 not including the voltage amplifier 300, when the voltage of the battery cell B is greater than or equal to the first reference voltage. According to an embodiment, the battery management apparatus may electrically connect the battery cell B to the impedance calculation unit 400 through the second path 221 including the voltage amplifier 300, when the voltage of the battery cell B is less than the first reference voltage.

According to an embodiment, the battery management apparatus may electrically connect the battery cell B to the impedance calculation unit 400 through the first path 211 by short-circuiting the first switch 210 arranged on the first path 211 and opening the second switch 220 arranged on the second path 221 including the voltage amplifier 300, when the voltage of the battery cell B is greater than or equal to the first reference voltage. According to an embodiment, the battery management apparatus may electrically connect the battery cell B to the impedance calculation unit 400 through the second path 221 by opening the first switch 210 arranged on the first path 211 and short-circuiting the second switch 220 arranged on the second path 221 including the voltage amplifier 300, when the voltage of the battery cell B is less than the first reference voltage.

According to an embodiment, the battery management apparatus may adjust a magnitude of alternating current flowing to the battery cell B through the third path 411 based on the comparison result of operation S100.

According to an embodiment, the battery management apparatus may adjust the magnitude of the alternating current flowing through the third path 411 by adjusting the resistance value of the variable resistor 520, when the voltage of the battery cell B is greater than or equal to the second reference voltage. According to an embodiment, the battery management apparatus may set a resistance value of the variable resistor 520 to the first resistance value, when the voltage of the battery cell B is greater than or equal to the second reference voltage. The battery management apparatus may set a resistance value of the variable resistor 520 to the second resistance value, when the voltage of the battery cell B is less than the second reference voltage. Herein, the second resistance value may be less than the first resistance value.

According to an embodiment, the variable resistor 520 may include a fourth switch 521, a first resistor 523, and a second resistor 525. According to an embodiment, the first resistor 523 and the second resistor 525 may be connected to each other in parallel between the battery cell B and the third switch 410 on the third path 411. The fourth switch 521 may be connected serially to the second resistor 525.

According to an embodiment, the battery management apparatus may open the fourth switch 521, when the voltage of the battery cell B is greater than or equal to the second reference voltage. In this case, the alternating current may flow through only the first resistor 523.

According to an embodiment, the battery management apparatus may short-circuit the fourth switch 521, when the voltage of the battery cell B is less than the second reference voltage. In this case, the alternating current may flow through the first resistor 523 and the second resistor 525 connected in parallel.

In operation S300, the battery management apparatus may calculate the impedance of the battery cell B based on a voltage applied to the impedance calculation unit 400. According to an embodiment, the battery management apparatus may calculate the impedance of the battery cell B based on the first voltage applied to the impedance calculation unit 400 through the first path 211 including the first switch 210 or the second voltage applied to the impedance calculation unit 400 through the second path 221 including the voltage amplifier 300. According to an embodiment, the battery management apparatus may calculate the impedance of the battery cell B based on the amount of change of the first voltage or the amount of change of the second voltage. According to another embodiment, the battery management apparatus may calculate the impedance of the battery cell B based on a differential value of the first voltage or a differential value of the second voltage.

first path 211 second path 221 first path 211 second path 221 The operating method of the battery management apparatus according to the embodiment may be implemented in the form of an application or a program instruction that is executable through various computer components and recorded in a computer-readable recording medium. The computer-readable recording medium may include a program instruction, a data file, a data structure and the like solely or in a combined manner.

According to the battery management apparatus described above, it is possible to conveniently measure an impedance for both a general battery cell and a low-voltage battery cell without a need to separately use a measurement device according to an operating voltage of a battery cell, and to obtain state information of a battery cell, such as deterioration, remaining lifetime, abnormality, etc., by using a Nyquist plot drawn according to an alternating current impedance response for each frequency.

So far, all components constituting the embodiment have been described as being combined or operating in combination, but it is not necessarily limited to this embodiment, and within the scope of the purpose, all components may be selectively combined with one or more to operate. Moreover, terms such as "include", "constitute", "have", etc., described above may mean that the corresponding component may be inherent unless otherwise stated, and thus should be construed as further including other components rather than excluding other components.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery management apparatus comprising:
a first comparator configured to compare a voltage of a battery cell with a first reference voltage;
a switching circuit configured to set a path in which the battery cell is electrically connected to an impedance calculation unit to a first path or a second path, based on a comparison result of the first comparator; and
the impedance calculation unit configured to calculate an impedance of the battery cell based on a first voltage applied through the first path or a second voltage applied through the second path.

2. The battery management apparatus of claim 1, further comprising a voltage amplifier arranged on the second path,
wherein the voltage amplifier is further configured to amplify the voltage of the battery cell to the second voltage, when the path is set to the second path.

3. The battery management apparatus of claim 1, wherein the switching circuit comprises a first switch arranged on the first path and a second switch arranged on the second path, and
when the voltage of the battery cell is greater than or equal to the first reference voltage, the path is set to the first path by short-circuiting the first switch and opening the second switch, and
when the voltage of the battery cell is less than the first reference voltage, the path is set to the second path by opening the second switch and short-circuiting the second switch.

4. The battery management apparatus of claim 1, further comprising a third switch electrically connected to the battery cell,
wherein the third switch alternates between on and off according to a designated period to generate alternating current (AC) input to the battery cell.

5. The battery management apparatus of claim 4, further comprising a current controller configured to adjust a magnitude of the alternating current based on a result of comparing the voltage of the battery cell with a second reference voltage.

6. The battery management apparatus of claim 5, wherein the current controller further comprises a variable resistor, and
when the voltage of the battery cell is greater than or equal to the second reference voltage, the variable resistor is set to have a first resistance value, and
when the voltage of the battery cell is less than the second reference voltage, the variable resistor is set to have a second resistance value less than the first resistance value.

7. The battery management apparatus of claim 1, wherein the first comparator is further configured to adjust the first reference voltage based on a change of the voltage of the battery cell in a predetermined time window.

8. The battery management apparatus of claim 7, wherein the first comparator is further configured to:
increase the first reference voltage when the voltage of the battery cell increases by a first designated level or more in a predetermined time window; and
reduce the first reference voltage when the voltage of the battery cell decreases by a second designated level or more in a predetermined time window.

9. An operating method of a battery management apparatus, the operating method comprising:
comparing a voltage of a battery cell with a first reference voltage;
setting a path in which the battery cell is electrically connected to an impedance calculation unit to a first path or a second path, based on a result of comparing the voltage of the battery cell with the first reference voltage; and
calculating an impedance of the battery cell based on a first voltage applied to the impedance calculation unit through the first path or a second voltage applied to the impedance calculation unit through the second path.

10. The operating method of claim 9, further comprising amplifying the voltage of the battery cell to the second voltage through a voltage amplifier arranged on the second path, when the path is set to the second path.

11. The operating method of claim 9, further comprising a third switch, electrically connected to the battery cell, alternating between on and off according to a designated period to generate alternating current (AC) input to the battery cell.

12. The operating method of claim 11, further comprising adjusting a magnitude of the alternating current based on a result of comparing the voltage of the battery cell with a second reference voltage.

13. The operating method of claim 12, wherein the adjusting of the magnitude of the alternating current comprises:
when the voltage of the battery cell is greater than or equal to the second reference voltage, setting a variable resistor arranged on a path through which the alternating current flows to have a first resistance value; and
when the voltage of the battery cell is less than the second reference voltage, setting the variable resistor to have a second resistance value less than the first resistance value.

14. The operating method of claim 9, further comprising adjusting the first reference voltage based on a change of the voltage of the battery cell in a predetermined time window.

15. The operating method of claim 14, wherein the adjusting of the first reference voltage comprises:
increasing the first reference voltage when the voltage of the battery cell increases by a first designated level or more in a predetermined time window; and
reducing the first reference voltage when the voltage of the battery cell decreases by a second designated level or more in a predetermined time window.
